# EUROPEAN PATENT APPLICATION

(11) **EP 4 583 173 A1**
(43) Date of publication of application: **09.07.2025**
(21) Application number: 23874663.0
(22) Date of filing: 21.09.2023
(51) Int. Cl.: H01L 33/54, H01L 33/62

(54) **SEMICONDUCTOR LIGHT EMITTING DEVICE**

(30) Priority: 05.10.2022 JP 2022161152
(71) Applicant: Stanley Electric Co. Ltd., Tokyo 153-8636 (JP)
(72) Inventor: TAI, Kohei, Tokyo 153-8636 (JP); TABUCHI, Kenji, Tokyo 153-8636 (JP); SHIINA, Kodai, Tokyo 153-8636 (JP)
(74) Representative: Wimmer, Hubert
(86) International application number: PCT/JP2023/034301
(87) International publication number: WO 2024/075534

(57) **Abstract**

The present invention provides a light emitting device which prevents peeling between a resin and a lead frame and is high in bonding strength, and prevents disconnection defect of wiring, curling of a resin molded body, internal damage and the like. A light emitting device 10 includes a substrate molded body 11 which is composed of plate-like leads 12A, 12B, and 12C and a resin frame 11A in which the leads 12A, 12B, and 12C are embedded, and has an upper surface 11S and a back surface 11R parallel to each other from which the leads 12A, 12B, and 12C are exposed, light emitting elements 21 and 22 mounted on the leads 12A, 12B, and 12C exposed from the upper surface 11S of the substrate molded body 11, and a sealing member 30 which covers the upper surface 11S of the substrate molded body 11 and the light emitting elements 21 and 22. The substrate molded body 11 has an outer edge portion having an annular step portion ST, which is recessed from the upper surface 11S. The leads 12A, 12B, and 12C respectively have first protruding portions 12A1, 12B1, and 12C1 which protrude from lead bodies 12AM, 12BM, and 12CM toward an outer edge of the substrate molded body 11 and have entire end surfaces CE of protruding ends thereof which are exposed on the same plane as a side surface SA of the step portion ST. The sealing member 30 has an outer edge convex portion 30S which covers the step portion ST of the substrate molded body 11.

## Description

### Technical Field

The present invention relates to a light emitting device, particularly to a light emitting device in which a semiconductor light emitting element such as a light emitting diode (LED) is mounted on a lead frame.

### Background Art

There has heretofore been known a light emitting device which is formed by attaching a resin body to a lead frame by insert molding and then cutting it with a dicer.

There has been disclosed in Patent Literature 1, for example, a method of forming a light emitting device by forming a resin molded body on a lead frame provided with a cutout portion and cutting the resin molded body and the lead frame along the cutout portion.

There has also been disclosed in Patent Literature 2, a surface-mounted light emitting device having a first resin molded body formed by integrally molding a light emitting element and first and second leads, and a second resin molded body containing a phosphor which covers the light emitting element.

### Citation List

### Patent Literatures

Patent Literature 1: Japanese Patent Application Laid-Open No. 2010-62272
Patent Literature 2: Japanese Patent Application Laid-Open No. 2006-156704

### Summary of Invention

### Technical Problem

However, there was a risk of causing problems such as peeling between the resin and the lead frame, disconnection defect, corrosion progressing from the end surface of the lead frame, etc. due to the cutting of the integrally molded resin and lead frame. Further, there was a risk of causing problems such as damage to bonding members and connecting members, etc. inside the device due to curling of a resin molded body and cutting stress caused by cutting of the lead frame.

The present invention has been made in view of the above-described viewpoints, and aims to provide a light emitting device which aims to prevent peeling between a resin and a lead frame, and prevent corrosion from an end surface of the lead frame, disconnection defect, curling of a resin molded body, internal damage, and the like.

### Solution to Problem

There is provided a light emitting device according to one aspect of the present invention including:
a substrate molded body composed of a plurality of plate-shaped lead electrodes and a resin frame in which the plurality of lead electrodes are embedded, and having first and second main surfaces parallel to each other from which the plurality of lead electrodes are exposed;
a semiconductor light emitting element mounted on each of the lead electrodes exposed from the first main surface of the substrate molded body; and
a sealing member which covers the first main surface of the substrate molded body and the semiconductor light emitting element,
in which the substrate molded body has an annular step portion whose outer edge portion being recessed from the first main surface,
in which each of the plurality of lead electrodes has a first protruding portion protruding from a main body of the lead electrode toward an outer edge of the substrate molded body and having an entire end surface of a protruding end of the first protruding portion, which is exposed on the same plane as a side surface of the step portion, and
in which the sealing member has an outer edge convex portion which covers the step portion of the substrate molded body.

### Brief Description of Drawings

FIG. 1A is a view illustrating an upper surface of a light emitting device according to a first embodiment;
FIG. 1B is a view illustrating a side surface of the light emitting device according to the first embodiment;
FIG. 1C is a view illustrating a back surface of the light emitting device according to the first embodiment;
FIG. 2A is a top view schematically illustrating an internal structure of the light emitting device with a sealing member removed;
FIG. 2B is a view illustrating the light emitting device as viewed from a direction S perpendicular to a center line CX-CX illustrated in FIG. 2A;
FIG. 3A is a cross-sectional view illustrating a cross section of the light emitting device taken along line A-A illustrated in FIG. 2A;
FIG. 3B is a cross-sectional view illustrating a cross section of the light emitting device taken along line B-B illustrated in FIG. 2A;
FIG. 4A is a plan view illustrating an upper surface of a substrate molded body;
FIG. 4B is a cross-sectional view illustrating a cross section of the substrate molded body taken along line B-B illustrated in FIG. 4A;
FIG. 4C is a cross-sectional view illustrating a cross section of the substrate molded body taken along line A-A illustrated in FIG. 4A;
FIG. 5A is a plan view illustrating Step S1 of a manufacturing process of the light emitting device;
FIG. 5B is a plan view illustrating Step S2 of the manufacturing process of the light emitting device;
FIG. 5C is a plan view illustrating Steps S3 and S4 of the manufacturing process of the light emitting device;
FIG. 5D is a plan view illustrating Step S5 of the manufacturing process of the light emitting device;
FIG. 5E is a plan view illustrating Step S6 of the manufacturing process of the light emitting device;
FIG. 5F is a plan view illustrating Step S7 of the manufacturing process of the light emitting device;
FIG. 5G is a plan view illustrating Step S8 of the manufacturing process of the light emitting device;
FIG. 5H is a plan view illustrating Step S9 of the manufacturing process of the light emitting device;
FIG. 6 is a cross-sectional view illustrating a cross section of a light emitting device according to a first modification of the first embodiment;
FIG. 7 is a cross-sectional view illustrating a cross section of a light emitting device according to a second modification of the first embodiment; and
FIG. 8 is a cross-sectional view illustrating a cross section of a light emitting device according to a third modification of the first embodiment.

### Description of Embodiments

Preferred embodiments of the present invention will hereinafter be described, but they may be modified and combined as appropriate. Further, in the following description and accompanying drawings, parts which are substantially the same or equivalent will be described given the same reference numerals.

### [First Embodiment]

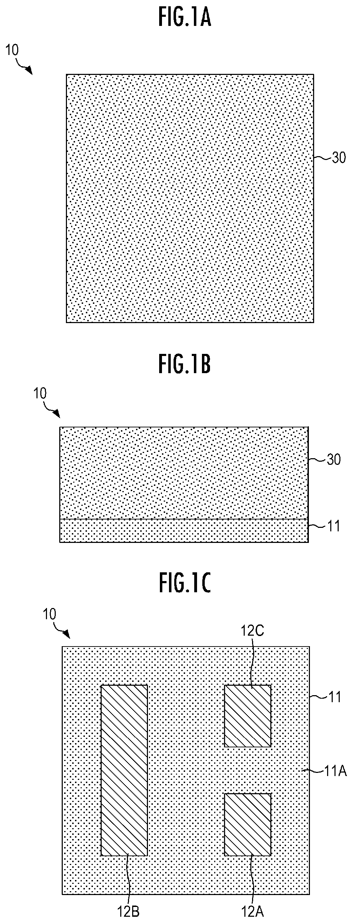

FIGS. 1A, 1B, and 1C are views illustrating upper, side, and back surfaces, respectively, of a light emitting device 10 according to a first embodiment of the present invention. The light emitting device 10 has a sealing member 30 formed on a substrate molded body 11.

As illustrated in FIG. 1C, the substrate molded body 11 of the light emitting device 10 has a plurality of plate-like lead electrodes (hereinafter also simply referred to as leads) and a resin frame 11A. More specifically, the light emitting device 10 has a first lead 12A, a second lead 12B, and a third lead 12C exposed from the back surface of the light emitting device 10.

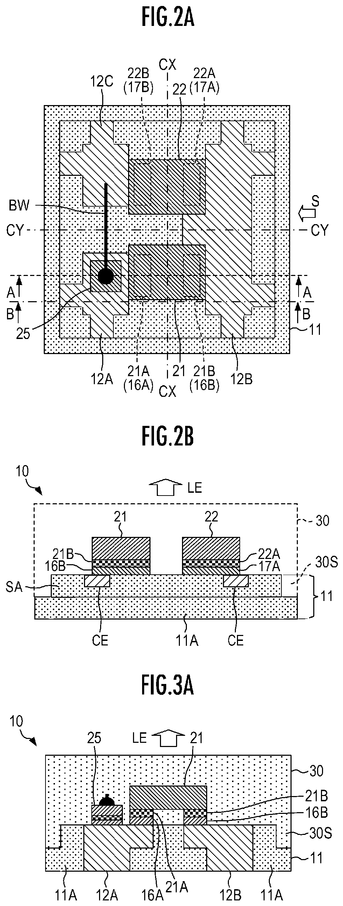

FIG. 2A is a top view schematically illustrating an internal structure of the light emitting device 10 with the sealing member 30 removed. FIG. 2B is a side view illustrating the light emitting device 10 as viewed from a direction (direction S in the figure) perpendicular to a center line CX-CX illustrated in FIG. 2A. Note that, to make it easier to understand the internal structure, FIG. 2B schematically illustrates the state in which the sealing member 30 is removed.

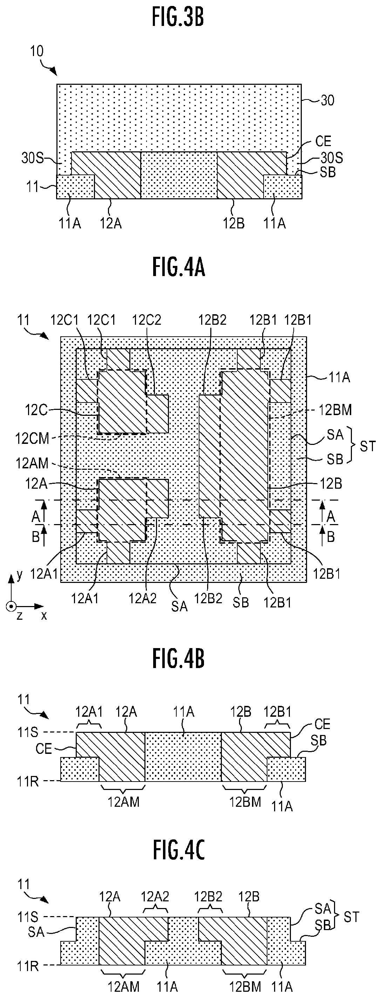

Further, FIG. 3A is a cross-sectional view illustrating a cross section of the light emitting device 10 taken along line A-A illustrated in FIG. 2A. FIG. 3B is a cross-sectional view illustrating a cross section of the light emitting device 10 taken along line B-B illustrated in FIG. 2A.

As illustrated in FIGS. 2A, 2B, and 3A, two semiconductor light emitting elements (hereinafter simply referred to as light emitting elements) 21 and 22 are mounted by being bonded to leads exposed from an upper surface of the substrate molded body 11.

More specifically, as illustrated in FIGS. 2A and 3A, the light emitting element 21 has a first electrode 21A (for example, an anode) and a second electrode 21B (for example, a cathode) on its back surface, which are element electrodes. The first electrode 21A is electrically connected to the first lead 12A by a bonding part 16A, and the second electrode 21B is electrically connected to the second lead 12B by a bonding part 16B.

Further, the light emitting element 22 has a first electrode 22A (for example, an anode) and a second electrode 22B (for example, a cathode) on its back surface. The first electrode 22A is electrically connected to the second lead 12B by a bonding part 17A, and the second electrode 22B is electrically connected to the third lead 12C by a bonding part 17B.

In this case, the first lead 12A and the third lead 12C function as the anode and cathode of the light emitting device 10, respectively. The second lead 12B functions as an intermediate electrode (relay electrode) which connects the light emitting element 21 and the light emitting element 22 in series.

As illustrated in FIGS. 2B and 3A, the light emitting elements 21 and 22 have upper surfaces as emitting surfaces and emit emission light LE upwardly of the elements. More specifically, continuous side surfaces made of the same material as the upper surfaces of the light emitting elements 21 and 22 are sub-emitting surfaces and emit a certain amount of emission light toward the sides of the elements as well.

The light emitting elements 21 and 22 are, for example, semiconductor light emitting diodes (LEDs) which emit blue emitting light. Specifically, the light emitting elements 21 and 22 are gallium nitride LEDs in each of which a semiconductor structure layer including an n-type semiconductor layer, a light emitting layer, and a p-type semiconductor layer is formed.

Note that the light emitting elements 21 and 22 are not limited to blue in light emission color, and may use a semiconductor structure layer of a crystal system other than the gallium nitride system. Further, the light emitting elements 21 and 22 are not limited to LEDs, and may be a semiconductor laser, etc.

The sealing member 30 is formed to cover the entire upper surface 11S of the substrate molded body 11 and to embed the members provided on the substrate molded body 11, such as the light emitting elements 21 and 22.

The sealing member 30 is made of a translucent resin containing a wavelength conversion material. A silicone resin, an epoxy resin, an acrylic resin, or the like can be used as the translucent resin.

Also, the wavelength conversion material contains phosphor particles which receive blue LED light and emit yellow light. Therefore, white light is emitted from an emitting surface of the sealing member 30. Further, the wavelength conversion material may be phosphor particles which receive blue LED light and emit green light, red light, and green-yellow light. In addition, the wavelength conversion material may be nano-wavelength conversion particles which have a similar effect.

Note that the phosphor is not particularly limited, but various phosphors such as YAG (yttrium aluminum garnet), LuAG (lutetium aluminum garnet), GYAG (gadolinium aluminum garnet), α, β sialon, SCASN, CASN, and KSF can be used as appropriate.

Further, as the nano wavelength conversion particles, quantum dots (QD: Quantum Dot) of a II-VI group, a II-V-VI group, a III-V group, a I-III-IV group, and an IV-VI group such as a CdTe system, a ZnCdSe system, an InN system, an AgInS₂ system, and a PdS system can be used as appropriate. Note that in the case of the nano wavelength conversion particles, they can be directly applied to the emitting surfaces of the light emitting elements 21 and 22.

In addition, the light emitting device 10 is provided with a protective element 25 which is bonded to the first lead 12A and electrically connected to the second electrode 21B by a bonding wire BW. That is, the protective element 25 is connected in parallel with the light emitting element 21 and the light emitting element 22 connected in series.

The protective element 25 can include a Zener diode, but is not limited to it. A varistor or the like may also be used as the protective element 25. Further, the protective element 25 may be provided with a passive element such as a capacitor, a resistor, or a light receiving element.

### (1) Resin Frame and Leads

The substrate molded body 11 will hereinafter be described in detail with reference to the drawings. FIG. 4A is a plan view illustrating the upper surface of the substrate molded body 11. FIGS. 4B and 4C are cross-sectional views illustrating cross sections of the substrate molded body 11 taken along lines B-B and A-A, respectively, illustrated in FIG. 4A.

The substrate molded body 11 has a plurality of leads (hereinafter also referred to as a lead frame 12 of the light emitting device 10) composed of leads 12A, 12B, and 12C, and a resin frame 11A which holds the leads 12A, 12B, and 12C.

More specifically, the resin frame 11A is insert-molded onto the leads 12A, 12B, and 12C. The resin frame 11A is formed as a rectangular plate-shaped substrate molded body 11 while filling gaps between the leads.

The resin frame 11A is formed, for example, by adding light-reflecting particles such as titanium oxide particles to a silicone resin, an epoxy resin, or an acrylic resin. Alternatively, the resin frame 11A may be formed by adding light-absorbing particles such as carbon black to a silicone resin, an epoxy resin, or an acrylic resin.

The leads 12A, 12B, and 12C are formed apart from one another. Incidentally, in the following, when there is no particular distinction between the leads 12A, 12B, and 12C, they will simply be referred to as leads 12.

The core material (core member) of each of the leads 12A, 12B, and 12C is made of copper (Cu), which is a metal having a good etching property (corrosivity), and the surfaces thereof are plated with nickel/gold (Ni/Au) or nickel/palladium/gold (Ni/Pd/Au) which is a corrosion-resistant metal.

Further, the surfaces of the leads 12A, 12B, and 12C may be provided with a highly reflective nickel (Ni)/silver (Ag) plating layer.

If the outermost surface of each lead is made of corrosion-resistant Au, the bonding of the light emitting elements 21 and 22 to the leads 12A, 12B, and 12C, and the solder mounting of the light emitting device 10 onto a circuit board (not illustrated) can be carried out stably. Further, if the outermost surface thereof is made of Ag having a high reflectivity, the light output of the light emitting elements 21 and 22 can be improved.

Incidentally, as the core material of each of the leads 12A, 12B, and 12C (that is, the lead frame 12), aluminum (Al) which is a corrosive metal, an iron alloy such as iron-nickel-cobalt (Fe-Ni-Co), etc. can be used.

Further, a corrosion-resistant metal layer such as platinum (Pt), palladium (Pd), or rhodium (Rd) can be provided on the surfaces of the leads 12A, 12B, and 12C.

As illustrated in FIGS. 4B and 4C, the substrate molded body 11 has an upper surface 11S in which the upper surfaces of the leads 12A, 12B, and 12C are flush with the upper surface of the resin frame 11A. Also, the substrate molded body 11 is formed with a back surface 11R in which the back surfaces of the leads 12A, 12B, and 12C are flush with the back surface of the resin frame 11A. That is, the thickness of the resin frame 11A and the thickness of the lead frame 12 are the same.

Note that in the present specification, the "same" or "same surface" means substantially the same or same surface to the extent that the substrate molded body 11 is obtained by being formed from the lead frame 12 and the resin by insert molding or the like.

Therefore, the substrate molded body 11 has two main surfaces parallel to each other, i.e., the upper surface 11S (first main surface) and the back surface 11R (second main surface). Further, the leads 12A, 12B, and 12C are exposed at the upper surface 11S and the back surface 11R.

Note that it is preferable that the upper and back surfaces of the leads 12A, 12B, and 12C are flush with the upper and back surfaces of the resin frame 11A. However, they do not necessarily have to be flush with each other.

If the upper and back surfaces of the substrate molded body 11 are flush with each other, for example, it becomes easier to mount the light emitting elements 21 and 22 on the upper surface of the substrate molded body 11. It also becomes easier to mount the light emitting device 10 on the circuit board (not illustrated). That is, it is possible to prevent damage such as disconnection defect of wiring of the light emitting device 10. Further, even if the upper and back surfaces of the substrate molded body 11 are either flush or non-flush, the substrate molded body 11 prevents the leakage of light to the back surface side of the light emitting device 10 and blocks the intrusion of environmental gases and the like from the back surface.

As illustrated in FIGS. 4A to 4C, the leads 12A, 12B, and 12C respectively have lead bodies 12AM, 12BM, and 12CM (illustrated with surrounded by broken lines) and protruding portions provided around the lead bodies 12AM, 12BM, and 12CM and protruding within the lead surfaces. The protruding portions are each formed with a thin-walled portion which is thinner than the lead body.

More specifically, the leads 12A, 12B, and 12C have first protruding portions 12A1, 12B1, and 12C1 which protrude from the leads 12A, 12B, and 12C, respectively, toward the outer edge (side surface) of the substrate molded body 11.

Specifically, the lead 12A has two protruding portions 12A1 protruding in directions perpendicular to each other, and the lead 12C has two protruding portions 12C1 protruding in the perpendicular direction. Also, the lead 12B has four protruding portions 12B1 protruding in the perpendicular direction.

Further, the leads 12A and 12B have second protruding portions 12A2 and 12B2 protruding toward the other leads 12B and 12A, respectively. In addition, the leads 12C and 12B have second protruding portions 12C2 and 12B2 protruding toward the other leads 12B and 12C, respectively. That is, the lead 12B has two second protruding portions 12B2 which face the leads 12A2 and 12C2. Incidentally, in the present embodiment, the two protruding portions 12B2 are integrated.

The light emitting element 21 is mounted between the protruding portion 12A2 of the lead 12A and the protruding portion 12B2 of the lead 12B. The light emitting element 22 is mounted between the protruding portion 12C2 of the lead 12C and the protruding portion 12B2 of the lead 12B. The light emitting element 21 and the light emitting element 22 are connected in series.

As illustrated in FIGS. 4A to 4C, the first protruding portions 12A1, 12B1, and 12C1 and the second protruding portions 12A2, 12B2, and 12C2 are provided at the upper portions of the leads 12A, 12B, and 12C, and are formed as thin-walled portions thin in thickness. Incidentally, as illustrated in FIG. 2A, the lead 12C has a shape symmetrical to the lead 12A with respect to the center line CY.

More specifically, the first protruding portions 12A1, 12B1, and 12C1 and the second protruding portions 12A2, 12B2, and 12C2 are each formed by etching the back surface of the lead to a depth of, for example, about 50% of the thickness of the lead by so-called half etching.

Further, the back surfaces of the lead bodies 12AM, 12BM, and 12CM are exposed from the back surface of the substrate molded body 11 (refer to FIG. 1C). The exposed surfaces of the lead bodies 12AM, 12BM, and 12CM are mounting electrode surfaces when the light emitting device 10 is mounted on the wiring of the circuit board.

That is, lead peripheral portions other than the lead bodies 12AM, 12BM, and 12CM are made thin by etching from the back surface side. Therefore, this structure increases a bonding area between the leads 12A, 12B, and 12C and the resin of the resin frame 11A, and provides integration of a resin-filled portion, thereby making it possible to prevent peeling from the electrodes. Also, since they are made thin, the lead frame 12 can be easily cut.

Incidentally, description has been made about the case where the first protruding portions 12A1, 12B1, and 12C1 and the second protruding portions 12A2, 12B2, and 12C2 are formed as the thin-walled portions throughout, but the present invention is not limited to this, and the thin-walled portions may be partially provided at the ends of the protruding portions. That is, the first protruding portions 12A1, 12B1, and 12C1, and the second protruding portions 12A2, 12B2, and 12C2 may have ends (thin-walled ends) which are thinner in thickness than the lead bodies.

As illustrated in FIGS. 4A to 4C, a rectangular annular step portion ST is provided on an outer edge portion of the substrate molded body 11. The step portion ST is made up of a step side surface SA and a step bottom surface SB. More specifically, the entire side surface of the resin frame 11A of the substrate molded body 11 has a shape cut inwardly stepwise. There is provided the step portion ST where the upper surface of the resin frame 11A is recessed from the upper surface 11S of the substrate molded body 11.

Here, the step side surface SA of the resin frame 11A and end surfaces CE of the tips of the first protruding portions 12A1, 12B1, and 12C1 (hereinafter referred to as end surfaces CE of their protruding ends) are on the same plane, and as illustrated in FIG. 2B, the entire end surfaces CE of the protruding ends are exposed from the step side surface SA of the resin frame 11A.

Also, as illustrated in FIG. 4A, the ends (end surfaces CE) of the first protruding portions 12A1, 12B1, and 12C1 of the leads 12A, 12B, and 12C are located inside the outer surface of the substrate molded body 11 (i.e., the outer surface of the light emitting device 10) by the width of the step bottom surface SB of the step portion ST.

Incidentally, the first protruding portions 12A1, 12B1, and 12C1 can be formed by performing half dicing (separation groove forming process) between the substrate molded bodies 11 adjacent to one unit of substrate molded body 11 at the height (depth) of the step side surface SA of the step portion ST and the width of the step bottom surface SB so that they have such a shape included in the one unit of substrate molded body 11 after the insert molding. Therefore, a gap is defined between the leads lying between the adjacent substrate molded bodies 11. The end surface CE of the protruding end of the first protruding portion is located inwardly of the outer surface of the substrate molded body 11, and the core material of the lead frame 12 is exposed over the entire end surface CE.

Referring again to FIGS. 3A and 3B, the sealing member 30 covers the entire upper surface side of the substrate molded body 11, and embeds and seals the light emitting elements and the like provided on the upper surface of the substrate molded body 11.

More specifically, as illustrated in FIG. 3A, when the substrate molded body 11 on which the light emitting elements 21 and 22 are mounted is sealed with a sealing resin from thereabove, an outer edge convex portion (hereinafter also referred to as a sealing member skirt portion) 30S of the sealing member 30 is structured so as to cover the step portion ST over the entire outer edge of the substrate molded body 11. This therefore makes it possible to improve the bonding strength of the sealing member 30 and prevent peeling.

Also, as illustrated in FIG. 3B, the outer edge convex portion 30S of the sealing member 30 covers the end surfaces (cut end surfaces) CE of the protruding ends of the first protruding portions 12A1, 12B1, and 12C1 of the leads 12A, 12B, and 12C. Therefore, the end surfaces CE where the copper (Cu) as the electrode core material is exposed are covered by the sealing member 30, and corrosion due to the environmental gases or the like is prevented.

Further, the electrodes (lead frame) are not cut during a dicing process in the manufacture of the light emitting devices. That is, in the conventional method of cutting the leads during dicing, the cutting stress of the leads extends to the inside of the light emitting device. However, according to the present embodiment, since the leads are not cut during dicing, the cutting stress to the inside of the light emitting device does not occur, and it is possible to prevent breakage of connecting members and internal damage to element bonding part, etc. and to manufacture a highly reliable light emitting device.

Incidentally, in the present embodiment, description has been made about the case where the second lead 12B which functions as the intermediate electrode (relay electrode) is provided. By providing such an intermediate electrode (second lead 12B), the second lead 12B functions as a heat dissipation path common to the light emitting elements 21 and 22. It is therefore possible to improve the light output of the light emitting device 10 under a high temperature environment. Further, the intermediate electrode balances the temperatures of the plural light emitting elements and helps the plural light emitting elements to exhibit stable optical characteristics.

Incidentally, description has been made about the case where the first protruding portions 12A1, 12B1, and 12C1 are provided at the upper surface portions of the leads 12A, 12B, and 12C, respectively. However, the first protruding portions 12A1, 12B1, and 12C1 may be provided in the centers of the leads 12A, 12B, and 12C in their thickness direction. In this case, the first protruding portions can be formed by etching the leads even from the upper surface side in addition to etching the leads from the back surface side.

In the above-described embodiment, description has been made about the substrate molded body 11 provided with the three leads including the second lead 12B (relay electrode), but it is sufficient that the substrate molded body 11 is provided with two or more leads without being limited to it. Also, in this case, each lead may have the first protruding portion which protrudes toward the outer edge of the substrate molded body 11.

Further, although the light emitting device provided with the two light emitting elements has been described, at least one light emitting element may be provided.

### (2) Manufacturing Method of Light Emitting Device

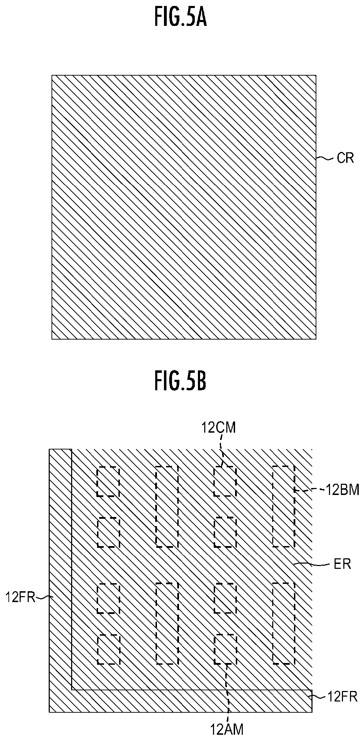

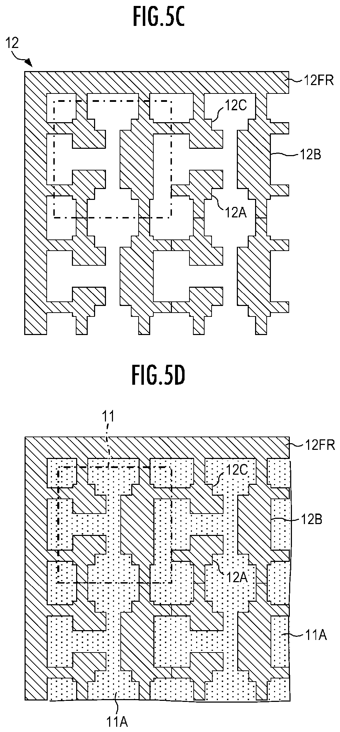

The manufacturing method of a light emitting device 10 will hereinafter be described in detail with reference to the drawings. FIGS. 5A to 5H are plan views illustrating Steps S1 to S8 of a manufacturing process of the light emitting device 10. Note that FIGS. 5A and 5B illustrate the back surface of a core material CR for the lead frame, and FIGS. 5C to 5H illustrate the upper surface side of a lead frame 12 (the mounting surface side for light emitting elements 21 and 22).

### (S1) Preparation of Core Material

A core material CR for the lead frame 12 having a size sufficient to form a plurality of light emitting devices is first prepared (FIG. 5A). As the core material CR, for example, copper (Cu) or a copper alloy is used.

### (S2) Half Etching Process

A portion (half etching region ER) excluding lead bodies 12AM, 12BM, and 12CM which are the electrode mounting portions of the light emitting device 10, and an outer frame 12FR of the core material CR (lead frame 12) is made thin by etching 1/3 to 2/3 of the thickness of the core material CR (FIG. 5B: back surface of the core material CR).

### (S3) Punching Process

The portions of the core material CR other than those becoming the leads 12A, 12B, and 12C are punched out to form the lead frame 12 (FIG. 5C: the upper surface of the lead frame 12). That is, the lead frame 12 is made up of leads of a plurality of light emitting devices 10, which are connected together. Note that a region corresponding to one unit of the light emitting device 10 is indicated by a broken line.

Further, the lead frame 12 can also be formed by an etching process similar to the previous S2 process. Specifically, the back surface side (FIG. 5B) of the lead frame after completion of the etching process S2 is fully protected with a resist or the like, and then the portions which will become the leads 12A, 12B, and 12C on the surface side of the lead frame (FIG. 5C) are protected with a resist mask. After that, the portion of the lead frame which is not protected with the resist mask can be removed by etching to form the lead frame 12.

### (S4) Plating Process

The surface of the lead frame 12 is plated with nickel (Ni)/gold (Au) and nickel/palladium/gold (Ni/Pd/Au) to form a plating layer (FIG. 5C).

### (S5) Resin Filling Process

The lead frame 12 is sandwiched by a molding die. Next, a thermosetting resin is injected into the molding die while being heated, and is cured to form a resin molded body (insert molding) (FIG. 5D).

Incidentally, a light-transmitting and thermosetting silicone resin was used, and titanium oxide (TiO₂) particles were contained as light-reflecting particles. The particle size of the TiO₂ particles is preferably 200nm to 300nm, and the filling amount thereof is preferably 8wt% to 54wt%.

The resin is filled into the gaps in the lead frame 12 and the half etching region ER. Consequently, it is possible to obtain a molded body in which the substrate molded body 11 is connected by the resin. Note that in FIG. 5D, a region corresponding to one unit of the substrate molded body 11 is illustrated by a dot chain line.

Further, the thickness of the resin frame 11A is the same as the thickness of the lead frame 12, and the front and back surfaces of the substrate molded body 11 are flat. By making the thickness of the resin frame 11A the same as that of the lead frame 12 in this way, it is possible to prevent curling of the substrate molded body 11 which is a resin molded body. In addition, peeling between the resin frame 11A and the lead frame 12 can also be prevented because no curling occurs.

### (S6) Separation Groove Forming Process

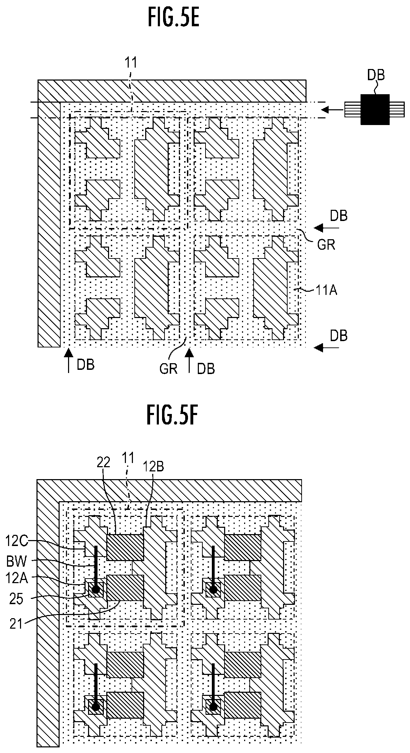

A separation groove GR is formed in the resin-filled lead frame 12 using a dicer. More specifically, the resin frame 11A of the resin molded body 11 and the lead frame 12 are cut from the upper surface side (element mounting surface side) by a dicing blade DB to form the separation groove GR (FIG. 5E). The separation groove GR can also be formed by laser processing other than dicing. For example, the separation groove GR can be formed by scanning such as weaking the irradiation intensity of a resin part and increasing the irradiation intensity of the lead frame 12 part. The leads 12A, 12B, and 12C are separated into one unit of the substrate molded body 11 by the separation groove forming process in this way.

More specifically, the depth of the separation groove GR is equal to or greater than the thickness of the first protruding portions 12A1, 12B1, 12C1 and the second protruding portions 12A2, 12B2, and 12C2, which are the thin-walled portions of the leads 12A, 12B, and 12C. Further, the groove width is not limited to this, but is, for example, about 0.2 to 0.4 mm.

In FIG. 5E, a region corresponding to one unit of the substrate molded body 11 is indicated by a dot chain line.

### (S7) Element Mounting Process

Solder paste is applied onto the protruding portions 12A2, 12B2, and 12C2 of the leads 12A, 12B, and 12C, and the lead 12A (FIG. 5F; also refer to FIGS. 2A and 3A). Next, the light emitting elements 21 and 22, and the protective element 25 are placed so that the solder paste and the element electrodes overlap each other, and the solder paste is heated to a temperature at which it melts, thereby bonding the light emitting elements 21 and 22 and the protective element 25 to the respective leads.

The melting temperature is, for example, about 300°C for Au-20wt% Sn solder and about 240°C for Sn-Ag-Cu solder. Also, anisotropic conductive paste may be used. In that case, the melting temperature is about 180°C.

In the present embodiment, since the substrate molded body 11 as the resin molded body is flat without being curled, the light emitting elements 21 and 22 can be accurately bonded, thereby making it possible to reduce the disconnection defect. Further, even after bonding the light emitting elements 21 and 22, stress caused by curling of the substrate molded body 11 is not applied to the bonding part, so that the disconnection defect can be prevented.

When wire bonding is required, the element electrode (e.g., the element electrode of the protective element 25) and the corresponding lead are connected with a bonding wire BW (Au wire). In the present embodiment, the bonding wire BW connects between the element electrode of the protective element 25 and the lead 12C.

### (S8) Sealing Member Forming Process

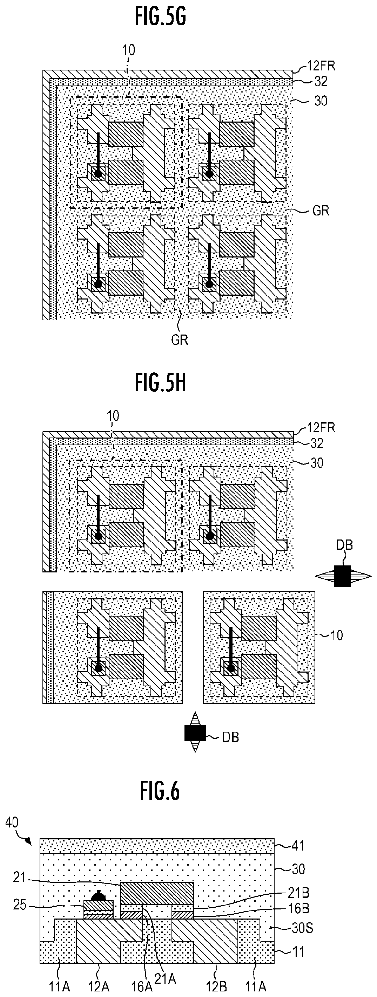

A dam frame 32 is formed on the upper surface of the outer frame 12FR of the lead frame 12 using a resin (FIG. 5G). Incidentally, in FIG. 5G, one unit of the light emitting device 10 is indicated by a dot chain line. Further, in order to facilitate understanding of the relationship between one time of the light emitting device 10 and the internal structure, the internal structure in the light emitting device 10, such as the leads, light emitting elements, and protective element is illustrated.

After the formation of the dam frame 32, a resin containing a phosphor which becomes a sealing member 30 is injected into the inside of the dam frame 32 by an amount sufficient to cover the elements, and heated and cured to form the sealing member 30. In the embodiment, a silicone resin containing a β-sialon phosphor which emits green fluorescence and a KFS phosphor which emits red fluorescence was used.

The sealing member can also be formed by a compression molding method. Specifically, a silicone resin containing a phosphor which becomes the sealing member 30 is poured by a predetermined amount into a mold with a recess into which the substrate molded body 11 (substrate molded body before dicing) fits. Next, the element mounting surface side of the substrate molded body 11 on which the elements are mounted is immersed in the silicone resin until the surface on which the elements are mounted soaks therein. In this state, the silicone resin is heated and cured to form the sealing member 30.

From the above, at this stage, the end surface CE of the protruding end of the lead frame 12 of the semiconductor molded body 11 is covered with the sealing member 30 and protected from the environmental gases.

### (S9) Dicing Process

The resin is cut along the center line of the separation groove GR by a thin dicing blade DB to cut out the light emitting devices 10 to be separated into individual pieces (FIG. 5H).

In this dicing, since only the resin is cut, the cutting can be done easily without applying stress to the inside of the light emitting element and the bonding parts of the light emitting element.

According to the above processes, the manufacturing of the light emitting device 10 is completed.

### [Modifications of First Embodiment]

Modifications of the first embodiment will be described below. FIG. 6 is a cross-sectional view illustrating a cross section of a light emitting device 40 which is a first modification of the first embodiment.

The light emitting device 40 of the first modification has a light diffusion layer 41 serving as a layer having light diffusivity, which is provided on the upper surface (light emitting surface) of the light emitting device 10 (refer to FIG. 3A) of the first embodiment, i.e., on the sealing member 30.

The diffusion layer 41 is, for example, a layer containing titanium oxide, zinc oxide, or white ceramic containing alumina or zirconia with a particle size of 10 µm to 50 µm. This diffuses light emitted from the light emitting element 21 and light emitted from a light conversion member contained in the sealing member 30.

By providing the diffusion layer 41, the directional characteristics of the light emitting device can be changed from approximately Lambertian to an umbrella shape with a wide half-value angle (directional angle at which the intensity becomes 50%).

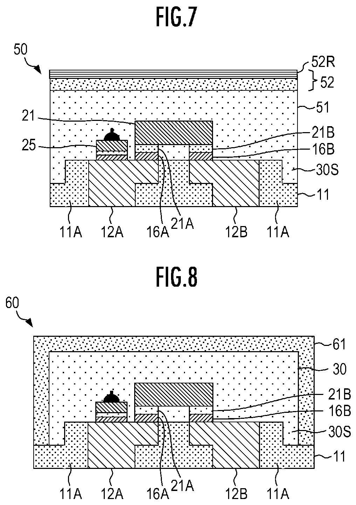

FIG. 7 is a cross-sectional view illustrating a cross section of a light emitting device 50 which is a second modification of the first embodiment. The light emitting device 50 of the second modification has a structure in which the sealing member 30 of the light emitting device 10 of the first embodiment (refer to FIG. 3A) is replaced with a transparent sealing member (hereinafter, transparent sealing member) 51. For example, the transparent sealing member 51 is made of a silicone resin.

Further, the light emitting device 50 has an optical reflection plate 52 provided on the upper surface of the transparent sealing member 51. The optical reflection plate 52 has an optical multilayer film 52R provided on a transparent glass plate.

For example, when the light emission color of the light emitting element 21 is blue (e.g., a wavelength of 445 nm), the optical multilayer film 52R has the property of reflecting light in a wavelength band of about 430 nm to 460 nm with a reflectance of 20% to 80%.

That is, the optical multilayer film 52R is set so that the transmittance of light perpendicularly incident on the optical multilayer film 52R becomes low, and the transmittance of light obliquely incident thereon becomes high. By providing the optical multilayer film in this way, the directional characteristics can be set from approximately Lambertian to an umbrella shape with a wide half-value angle (directional angle at which the intensity becomes 50%).

FIG. 8 is a cross-sectional view illustrating a light emitting device 60 which is a third modification of the first embodiment. The light emitting device 60 of the third modification has a gas-barrier coating layer 61 which covers the entire surface (i.e., upper surface and all four side surfaces) of the sealing member 30 of the light emitting device 10 of the first embodiment (refer to FIG. 3A).

More specifically, the sealing member 30 is outer-coated with a resin having high gas barrier properties, for example, a fluorine-based resin to form a coating layer 61. Therefore, the light emitting device 60 is excellent in durability and reliability due to shielding of environmental gases, etc.

Further, light extraction efficiency is improved by adopting as the resin for the coating layer 61, a resin with a low refractive index, such as a silicone resin with low refractiveness, or a silicone resin with nano-sized pores (pores) provided on its surface part.

As described in detail above, the present invention can provide a light emitting device which prevents peeling between a resin and a lead frame and also prevents disconnection defect, curling of a resin molded body, internal damage, and the like.

### Description of Reference Numerals

10, 40, 50, 60: light emitting device
11: substrate molded body
11A: resin frame
11S: upper surface (first main surface)
11R: back surface (second main surface)
12: lead frame
12A, 12B, 12C: lead (lead electrode)
12A1, 12B1, 12C1: first protruding portion
12A2, 12B2, 12C2: second protruding portion
12AM, 12BM, 12CM: lead body
21, 22: light emitting element (semiconductor light emitting element)
21A, 22A: first electrode (element electrode)
21B, 22B: second electrode (element electrode)
30: sealing member
30S: outer edge convex portion (sealing member skirt portion)
41: light diffusion layer
51: transparent sealing member
52R: optical multilayer film
61: gas barrier coating layer
CE: end surface of protruding end
GR: separation groove
ST: step portion
SA: step side surface
SB: step bottom surface

## Claims

1. A semiconductor light emitting device, comprising:
a substrate molded body composed of a plurality of plate-shaped lead electrodes and a resin frame in which the plurality of lead electrodes are embedded, and having first and second main surfaces parallel to each other from which the plurality of lead electrodes are exposed;
a semiconductor light emitting element mounted on each of the lead electrodes exposed from the first main surface of the substrate molded body; and
a sealing member which covers the first main surface of the substrate molded body and the semiconductor light emitting element,
wherein the substrate molded body has an outer edge portion having an annular step portion recessed from the first main surface,
wherein each of the plurality of lead electrodes has a first protruding portion protruding from a main body of the lead electrode toward an outer edge of the substrate molded body and having an entire end surface of a protruding end of the first protruding portion, which is exposed on the same plane as a side surface of the step portion, and
wherein the sealing member has an outer edge convex portion which covers the step portion of the substrate molded body.

2. The semiconductor light emitting device according to Claim 1, wherein the first protruding portion has a thin-walled end portion which is smaller in thickness than the main body of the lead electrode.

3. The semiconductor light emitting device according to Claim 1, wherein the end surface of the protruding end of the first protruding portion is a cut end surface.

4. The semiconductor light emitting device according to Claim 1, wherein a plating layer is applied to surfaces of the plurality of lead electrodes except for the end surface of the protruding end of the first protruding portion, and a core material of the lead electrode is exposed on the end surface of the protruding end.

5. The semiconductor light emitting device according to Claim 1, wherein each of the plurality of lead electrodes protrudes toward the other lead electrodes and has a second protruding portion exposed from the first main surface.

6. The semiconductor light emitting device according to Claim 5, wherein the second protruding portion has a thin-walled end portion which is smaller in thickness than the main body of the lead electrode.

7. The semiconductor light emitting device according to Claim 5, wherein an end surface of a protruding end of the second protruding portion is a cut end surface.

8. The semiconductor light emitting device according to Claim 5, wherein the semiconductor light emitting element is mounted on the second protruding portions of the plurality of lead electrodes.

9. The semiconductor light emitting device according to Claim 1, wherein the substrate molded body and the sealing member exposed on an outer surface of the semiconductor light emitting device are flush with each other.
